(19) Europäisches Patentamt
European Patent Office
Office européen des brevets

(11) **EP 4 451 558 A1**

(12) **EUROPEAN PATENT APPLICATION**
published in accordance with Art. 153(4) EPC

(43) Date of publication:
**23.10.2024 Bulletin 2024/43**

(21) Application number: **22905728.6**

(22) Date of filing: **07.04.2022**

(51) International Patent Classification (IPC):
*H03F 1/02* (2006.01)

(52) Cooperative Patent Classification (CPC):
**H03F 1/02; H03F 1/32; H03F 3/21**

(86) International application number:
**PCT/CN2022/085470**

(87) International publication number:
**WO 2023/108958 (22.06.2023 Gazette 2023/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.12.2021 CN 202111538991**

(71) Applicant: **Shaanxi Reactor Microelectronics Co., Ltd.**
**Xi'an, Shaanxi 710000 (CN)**

(72) Inventors:
• **RUAN, Jinlong**
**Shaanxi 710000 (CN)**
• **XIA, Qin**
**Shaanxi 710000 (CN)**

(74) Representative: **Zaboliene, Reda et al**
**Metida**
**Business center Vertas**
**Gyneju str. 16**
**01109 Vilnius (LT)**

(54) **POWER AMPLIFICATION CIRCUIT BASED ON ENVELOPE TRACKING TECHNOLOGY AND DOHERTY ARCHITECTURE, AND DESIGN METHOD THEREFOR**

(57)     A power amplifier circuit based on envelope tracking technology and Doherty architecture and a design method thereof, the circuit comprises a Doherty architecture and an external power supply; the external power supply is an ET power supply or an APT power supply; an output terminal of the ET power supply or APT power supply is connected to a drain electrode of a first transistor in the Doherty architecture; or the output terminal of the ET power supply or APT power supply is simultaneously connected to the drain electrodes of the first and second transistors in the Doherty architecture. The circuit makes a power amplifier work in the saturation state and therefore effectively improves the efficiency at the output power.

FIG. 3

## Description

Technical Field

The invention belongs to the technical field of communication base station, in particular to a power amplifier circuit based on envelope tracking technology and Doherty architecture and a design method thereof.

Background Art

At present, the power amplifier of the base station is designed with the Doherty architecture power amplifier circuit, which can balance the efficiency of outputting the average power and the linearity of outputting the peak power.

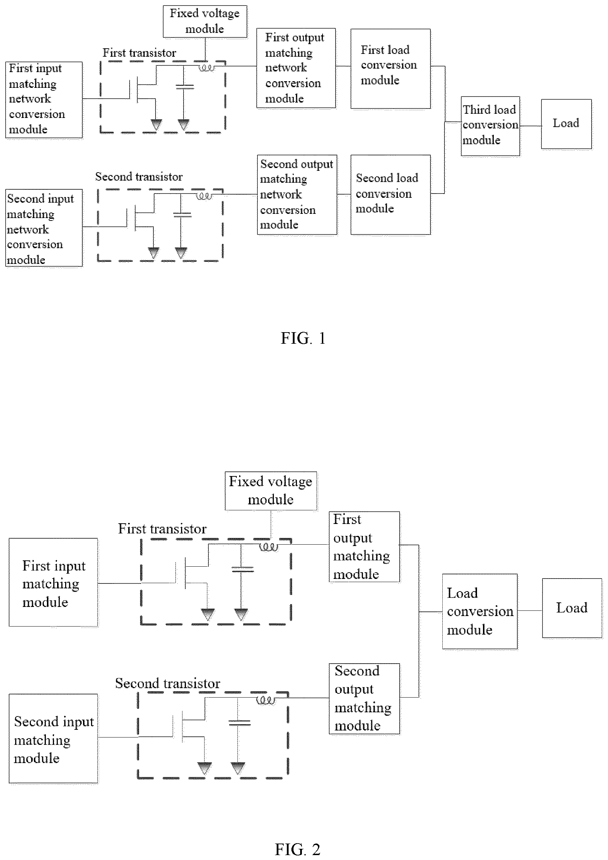

The structure principle of the traditional Doherty architecture power amplifier circuit suitable for narrow-band signals is shown in FIG. 1, including the Doherty architecture and the external power supply; The Doherty architecture includes the first input matching network conversion module, the second input matching network conversion module, the first transistor, the second transistor, the first output matching network conversion module, the second output matching network conversion module, the first load conversion module, the second load conversion module and the third load conversion module; The output terminal of the first input matching network conversion module is connected to the gate electrode of the first transistor; the output terminal of the second input matching network conversion module is connected to the gate electrode of the second transistor; The first transistor is grounded to the source electrode of the second transistor; The input terminal of the first output matching network conversion module is connected to the drain electrode of the first transistor; the input terminal of the second output matching network conversion module is connected to the drain electrode of the second transistor; The input terminal of the first load conversion module is connected to the output terminal of the first output matching network conversion module, and the input terminal of the second load conversion module is connected to the output terminal of the second output matching network conversion module; The input terminal of the third load conversion module is connected to the output terminals of the first load conversion module and the second load conversion module respectively; The output terminal of the third load conversion module is connected to the external load; The external power supply uses a fixed voltage module, and the output terminal of the fixed voltage module is connected to the drain electrode of the first transistor or connected to the drain electrodes of the first transistor and the second transistor respectively.

As the narrow-band characteristics of the traditional Doherty architecture power amplifier circuit gradually appear, domestic and foreign experts propose the double-matching Doherty architecture power amplifier circuit to solve the problem of narrower bandwidth, as shown in FIG. 2. The power amplifier circuit can solve the bandwidth problem well.

However, both Doherty architecture power amplifier circuit suitable for narrow bands and Doherty architecture power amplifier circuit suitable for broadbands have the following problems:
Since the fixed voltage module can only provide the fixed leakage voltage, the power amplifier circuit is in the linear region when the back-off of average output power expected by the base station occurs, so it is difficult to guarantee the efficiency.

Content of Invention

Aiming at the problem that it is difficult to guarantee the efficiency of the traditional Doherty architecture power amplifier circuit, the invention proposes a power amplifier circuit based on envelope tracking technology and Doherty architecture.

Meanwhile, the invention provides a design method of the circuit.

The purpose of the invention is realized by adopting the following technical proposal:

A power amplifier circuit based on envelope tracking technology and Doherty architecture comprises a Doherty architecture and an external power supply; the external power supply is an ET power supply or an APT power supply; an output terminal of the ET power supply or APT power supply is connected to a drain electrode of a first transistor in the Doherty architecture;

Or the output terminal of the ET power supply or APT power supply is simultaneously connected to the drain electrodes of the first and second transistors in the Doherty architecture.

Further, the Doherty architecture is suitable for narrow-band signals, or a double-matching Doherty architecture suitable for broadband signals.

The invention also provides a design method of the power amplifier circuit based on envelope tracking technology and Doherty architecture, which includes the following steps:

Step 1: Determine the saturation power P1 of the power amplifier circuit according to the given input signal peak-to-average ratio (PAR) and average effective output Pave;

$$P1 = Pave + PAR;$$

Step 2: Determine the saturation power value P1/2 of a single transistor in the Doherty architecture;

Step 3: Perform loadpull simulation by using the simulation software and calling a single transistor model, adjust the leakage voltage of the single transistor model, record the corresponding leakage voltage value of the transistor model when the saturation power of the transistor model is P1/2, take the leakage voltage value as the maximum voltage value $V_{max}$ of the ET power supply or APT power supply, record the corresponding leakage voltage value of the transistor model when the saturation power of the transistor model is Pave, and take the leakage voltage value as the average effective voltage $V_{rms}$ of the ET power supply or APT power supply;

Step 4: Get the minimum voltage value $V_{min}$ of the ET power supply or APT power supply through the maximum voltage value $V_{max}$ and the average effective voltage value $V_{rms}$, and obtain the voltage range of the ET power supply or APT power supply to select the appropriate ET power supply or APT power supply;

The specific calculation formula is as follows:

$$V_{rms} = \frac{P_1 V_{max} + P_2 V_{min}}{2};$$

Wherein, $P_1$ and $P_2$ are positive factors whose values are both more than 0 and less than 1;

Step 5: Match the ET power supply or APT power supply with the transistor;

Step 5.1: Obtain the impedance R2 at the end face of Plan A of the output terminal for the transistor current source when the transistor outputs the average power according to the optimal load value R1 of the selected ET power supply or APT power supply and the drain efficiency DE when the transistor outputs the rated power;

The specific calculation formula is as follows:

$$\frac{V_{rms}^2 * DE}{R_1} = \frac{(V_{rms} - V_1)^2}{2R_2},$$

Wherein, $V_1$ is the characteristic voltage of the transistor, and the drain efficiency DE for the transistor to output the rated power is obtained when Step 3 is performed.

Step 5.2: Convert the impedance of the load to the impedance R2 at the end face of Plan A of the output terminal for the transistor current source based on the Smith chart impedance transformation method to realize the matching of ET power supply or APT power supply with the transistor;

Step 6: The building of power amplifier circuit based on envelope tracking technology is completed.

Further, Advanced Design System is used as the simulation software.

Compared with the prior art, the invention has the following beneficial technical effects:

Compared with the traditional Doherty architecture power amplifier circuit and the double-matching Doherty architecture power amplifier circuit, the power amplifier circuit proposed by the invention can realize the effective matching between the Doherty architecture and ET/APT; when the optimal load value of the ET (Envelope Tracking) power supply or APT (Average Power Tracking power supply) and the equivalent resistance value of the transistor current source meet the matching conditions, the optimal matching effect between ET/APT and the transistors can be achieved, so that the overall efficiency of the whole ET/APT + transistors is optimal; when the output power is 3dB or 6dB back-off of the rated power, the power amplifier also works in the saturation state at the back-off power due to the use of a lower voltage value than the fixed leakage voltage, which can effectively improve the efficiency at the output power.

Description of Drawings

Various other advantages and benefits of the invention will become clear to the ordinary technicians in the field by reading the detailed description in the preferred embodiments below. The drawings to the specification are used only for the purpose of illustrating the preferred embodiments, but not considered to be a limitation to the invention. Obviously, the drawings described below only illustrate some embodiments of the invention, and other drawings may be obtained by the ordinary technicians in the field without creative effort according to these drawings. The same parts are represented by the same signs throughout the drawings.

FIG. 1 is the structure diagram of the traditional power amplifier circuit based on Doherty architecture suitable for narrow bands;

FIG. 2 is the structure diagram of the traditional power amplifier circuit based on Doherty architecture suitable for broadbands;

FIG. 3 is the structure diagram of the power amplifier circuit in Embodiment 1;

FIG. 4 is the structure diagram of the power amplifier circuit in Embodiment 2.

Embodiments

The embodiments of the invention are described in more detail with reference to the drawings below. Although the embodiments of the invention are illustrated in the drawings, it should be understood that the invention may be realized in various forms and should not be limited by the embodiments set forth herein. On the contrary, the embodiments are provided to enable a more thorough understanding of the invention and a complete communication of the scope of the invention to the technicians in the field.

It should be noted that certain terms are used in the specification and claims to refer to specific components. It should be understood by the technicians in the field that technicians may refer to the same component using different terms. In the specification and claims, the components are not distinguished by differences in terms, but distinguished by differences in component functions. For example, "comprise" or "include" mentioned throughout the specification and claims is an open term, so it should be interpreted as " including but not limited to". The subsequent description of the specification is the preferred embodiment of the invention, but the description is for the purpose of the general principles of the specification and is not intended to limit the scope of the invention. The scope of protection of the invention should be subject to the definition of the claims.

To understand the embodiments of the invention, the embodiments are further explained below in combination with the drawings, and the drawings do not constitute a limitation to the embodiments of the invention.

Envelope Tracking (ET) technology or Average Power Tracking (APT) technology can adjust the drain voltage of the power amplifier based on the size of the RF signal inputted by the power amplifier, which can ensure both the high linearity of peak signals and the high efficiency of mean signals and small signals. Therefore, ET_PA technology has always been the research focus of high efficiency scheme for the power amplifier.

The invention provides a power amplifier circuit based on envelope tracking technology and Doherty architecture, which comprises a Doherty architecture and an external power supply; the circuit is mainly improved in the following aspects: the external power supply is an ET power supply or APT power supply; the output terminal of the ET power supply or APT power supply is connected to the drain electrode of the first transistor in the Doherty architecture, or the output terminal of the ET power supply or APT power supply is connected to the drain electrodes of the first transistor and the second transistor in the Doherty architecture simultaneously;

When the ET power supply or APT power supply is connected to the first transistor, the matching between the ET power supply or APT power supply and the first transistor is only needed; when the ET power supply or APT power supply is connected to the first transistor and the second transistor simultaneously, the envelope tracking power supply is required to be matched with the first transistor and the second transistor respectively.

However, the invention is not a simple combination of ET power supply or APT power supply and Doherty architecture. To achieve the optimal matching between the ET power supply or APT power supply and the Doherty architecture to ensure the output efficiency of the transistors and realize the optimal overall efficiency of the entire ET/APT + transistors, the invention also provides a design method of the circuit, including the following steps:

Step 1: Determine the saturation power P1 of the power amplifier circuit according to the given input signal peak-to-average ratio (PAR) and average effective output Pave;

$$P1 = Pave + PAR;$$

Step 2: Determine the saturation power value P1/2 of a single transistor in the Doherty architecture;

Step 3: Perform loadpull simulation by using the simulation software (Advanced Design System) and calling a single transistor model, adjust the leakage voltage of the single transistor model, record the corresponding leakage voltage value of the transistor model when the saturation power of the transistor model is P1/2, take the leakage voltage value as the maximum voltage value $V_{max}$ of the ET power supply or APT power supply, record the corresponding leakage voltage value of the transistor model when the saturation power of the transistor model is Pave, and take the leakage voltage value as the average effective voltage $V_{rms}$ of the ET power supply or APT power supply;

Step 4: Get the minimum voltage value $V_{min}$ of the ET power supply or APT power supply through the maximum voltage value $V_{max}$ and the average effective voltage value $V_{rms}$, and obtain the voltage range of the ET power supply or APT power supply to select the appropriate ET power supply or APT power supply;

The specific calculation formula is as follows:

$$V_{rms} = \frac{P_1 V_{max} + P_2 V_{min}}{2};$$

Wherein, $P_1$ and $P_2$ are positive factors whose values are both more than 0 and less than 1;

Step 5: Match the ET power supply or APT power supply with the transistor;

Step 5.1: Obtain the impedance R2 at the end face of Plan A of the output terminal for the transistor current source when the transistor outputs the average power according to the optimal load value R1 of the selected ET power supply or APT power supply and the drain efficiency DE when the transistor outputs the rated power;

The specific calculation formula is as follows:

$$\frac{V_{rms}^2 * DE}{R_1} = \frac{(V_{rms} - V_1)^2}{2R_2},$$

Wherein, V1 is the characteristic voltage of the transistor, and the drain efficiency DE for the transistor to output the rated power is obtained when Step 3 is performed.

Step 5.2: Convert the impedance of the load to the impedance R2 at the end face of Plan A of the output terminal for the transistor current source based on the Smith chart impedance transformation method to realize the matching of ET power supply or APT power supply with the transistor;

Step 6: The building of power amplifier circuit based on envelope tracking technology is completed.

Based on the above description of the circuit improvement idea and design method of the invention, the invention is introduced in detail according to the following two embodiments:

Embodiment 1

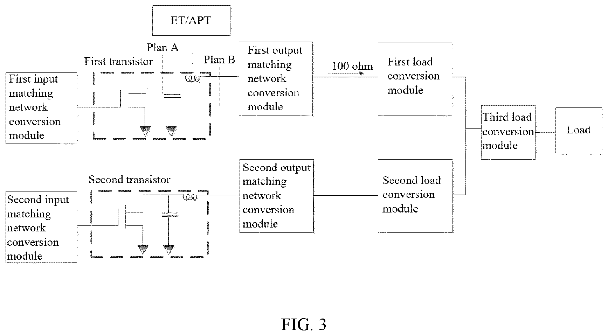

The embodiment provides a narrowband power amplifier circuit structure based on envelope tracking technology and Doherty architecture, as shown in FIG. 3, comprising a first input matching network conversion module, a second input matching network conversion module, a first transistor, a second transistor, an ET power supply or APT power supply, a first output matching network conversion module, a second output matching network conversion module, a first load conversion module, a second load conversion module and a third load conversion module;

The output terminal of the first input matching network conversion module is connected to the gate electrode of the first transistor; the output terminal of the second input matching network conversion module is connected to the gate electrode of the second transistor;

The first transistor is grounded to the source electrode of the second transistor; the first transistor and the second transistor respectively comprise an internal current source output terminal Plan A and an external output terminal Plan B;

The output terminal of the ET power supply or APT power supply is connected to the drain electrode of the first transistor, or the output terminal of the ET power supply or APT power supply is connected to the drain electrode of the first transistor and the second transistor simultaneously; in the embodiment, the ET power supply or APT power supply is only connected to the drain electrode of the first transistor;

The input terminal of the first output matching network conversion module is connected to the drain electrode of the first transistor; the input terminal of the second output matching network conversion module is connected to the drain electrode of the second transistor;

The input terminal of the first load conversion module is connected to the output terminal of the first output matching network conversion module, and the input terminal of the second load conversion module is connected to the output terminal of the second output matching network conversion module;

The input terminal of the third load conversion module is connected to the output terminals of the first load conversion module and the second load conversion module respectively;

The output terminal of the third load conversion module is connected to the external load;

In the embodiment, the functions of all components are as follows:

The first input matching network conversion module and the second input matching network conversion module are used to match the maximum gain impedance of the first transistor and the second transistor to the preset impedance;

The first transistor and the second transistor are used for signal amplification to facilitate signal transmission;

The ET power supply or APT power supply is used to provide variable voltage to the first and/or second transistors to improve the efficiency of the power amplifier;

The first output matching network conversion module and the second output matching network conversion module are used to match the maximum power point impedance of the first transistor and the second transistor to the preset impedance respectively;

The first load conversion module is used to realize the high efficiency of the power amplifier when the first transistor outputs the rated power output;

The second load conversion module is used to realize no effect on the circuit (namely, from the first input matching network conversion module to the load) where the first transistor is located when the second transistor circuit is connected; any effect will cause the efficiency for the first transistor to output the rated power to become low;

The third load conversion module is used to convert the load impedance to the input point impedance of the third load conversion module.

In the embodiment, the first output matching network conversion module and the second output matching network conversion module, the first input matching network conversion module and the second input matching network conversion module are composed of microstrip lines and capacitors; the first transistor and the second transistor respectively comprise an equivalent resistor, a voltage-controlled current source, a parasitic inductor and a parasitic capacitor.

In the embodiment, during operation, the first input matching network conversion module matches the load impedance of 50 ohms to the maximum gain impedance of the first transistor; the first output matching network conversion module matches the load of 50 ohms to the maximum power point (end face of Plan B) impedance of the first transistor; the first load conversion module and the third load conversion module work together to match the load of 50 ohms to 100 ohms, and the first output matching network conversion module matches the resistance of 100 ohms to the end face of Plan A.

The first output matching network conversion module matches the converted resistance of 100 ohms to the end face of Plan A, which is different from the traditional embodiment in which the converted resistance of 100 ohms is matched to the maximum efficiency point of the power amplifier (end face of Plan B) impedance.

Embodiment 2

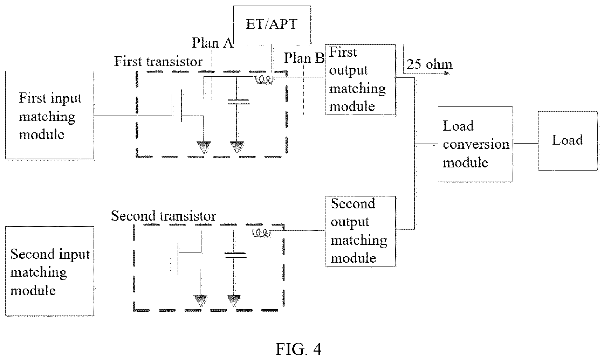

The embodiment provides a broadband power amplifier circuit based on envelope tracking technology and Doherty architecture, as shown in FIG. 4, comprising a first input matching module, a second input matching module, a first transistor, a second transistor, an ET power supply or APT power supply, a first output matching module, a second output matching module and a load conversion module;

The output terminal of the first input matching module is connected to the gate electrode of the first transistor; the output terminal of the second input matching module is connected to the gate electrode of the second transistor;

The first transistor is grounded to the source electrode of the second transistor; the first transistor and the second transistor respectively comprise an internal current source output terminal Plan A and an external output terminal Plan B;

The output terminal of the ET power supply or APT power supply is connected to the drain electrode of the first transistor, or the output terminal of the ET power supply or APT power supply is connected to the drain electrode of the first transistor and the second transistor simultaneously; in the embodiment, the ET power supply or APT power supply is only connected to the drain electrode of the first transistor;

The input terminal of the first output matching module is connected to the drain electrode of the first transistor; the input terminal of the second output matching module is connected to the drain electrode of the second transistor;

The input terminal of the load conversion module is connected to the output terminal of the first output matching module and the output terminal of the second output matching module;

The output terminal of the third load conversion module is connected to the external load;

In the embodiment, the first output matching module and the second output matching module, the first input matching module and the second input matching module are composed of microstrip lines and capacitors; the first transistor and the second transistor respectively comprise an equivalent resistor, a voltage-controlled current source, a parasitic inductor and a parasitic capacitor.

In the embodiment, during operation, the first input matching module matches the load impedance of 50 ohms to the maximum gain impedance of the first transistor; the first output matching module matches the load of 25 ohms to the optimal efficiency point impedance of the first transistor at small signals, and matches the load of 25 ohms to the maximum power point (end face of Plan B) impedance of the first transistor (where 25 ohms is the input point impedance of the load conversion module, which is obtained by adding the load cascade of 50 ohms through the load conversion module) at large signals; the load conversion module matches the load of 50 ohms to 25 ohms;

After the input signal is inputted to the first input matching module and overlapped with the signal flowing through the envelope tracking power supply, the load of 50 ohms is converted to 25 ohms by the load conversion module in turn, in which 25 ohms is obtained by adding the load cascade of 50 ohms through the load conversion module; the output matching module matches the converted resistance of 25 ohms the end face of Plan A.

In FIG. 3 and FIG. 4, the end face of Plan A represents the output terminal of the internal current source for the first transistor, namely the node of the dotted line and the solid line of Plan A in FIG. 3 and FIG. 4; the end face of Plan B represents the external output terminal of the first transistor, namely the node of the dotted and the solid line of Plan B in FIG. 3 and FIG. 4.

Although the embodiments of the invention are described in combination with the drawings, the invention is not limited to the embodiments and application fields described above, and the above embodiments are only indicative and instructive, rather than restrictive. Inspired by the specification, the ordinary technicians in the field can also make a variety of forms without departing from the scope of protection of the claims of the invention, which fall within the scope of protection of the invention.

## Claims

1. A power amplifier circuit based on envelope tracking technology and Doherty architecture, comprising a Doherty architecture and an external power supply, and **characterized in that**:

   The external power supply is an ET power supply or an APT power supply; an output terminal of the ET power supply or APT power supply is connected to a drain electrode of a first transistor in the Doherty architecture;
   Or the output terminal of the ET power supply or APT power supply is simultaneously connected to the drain electrodes of the first and second transistors in the Doherty architecture.

2. The power amplifier circuit based on envelope tracking technology and Doherty architecture according to Claim 1, **characterized in that** the Doherty architecture is suitable for narrow-band signals, or a double-matching Doherty architecture suitable for broadband signals.

3. A design method of the power amplifier circuit based on envelope tracking technology and Doherty architecture according to Claim 1, **characterized by** including the following steps:

   Step 1: Determine the saturation power P1 of the power amplifier circuit according to the given input signal peak-to-average ratio (PAR) and average effective output Pave;

   $$P1 = Pave + PAR;$$

   Step 2: Determine the saturation power value P 1/2 of a single transistor in the Doherty architecture;
   Step 3: Perform loadpull simulation by using the simulation software and calling a single transistor model, adjust the leakage voltage of the single transistor model, record the corresponding leakage voltage value of the transistor model when the saturation power of the transistor model is P1/2, take the leakage voltage value as the maximum voltage value $V_{max}$ of the ET power supply or APT power supply, record the corresponding leakage voltage value of the transistor model when the saturation power of the transistor model is Pave, and take the leakage voltage value as the average effective voltage $V_{rms}$ of the ET power supply or APT power supply;
   Step 4: Get the minimum voltage value $V_{min}$ of the ET power supply or APT power supply through the maximum voltage value $V_{max}$ and the average effective voltage value $V_{rms}$, and

obtain the voltage range of the ET power supply or APT power supply to select the appropriate ET power supply or APT power supply;
The specific calculation formula is as follows:

$$V_{rms} = \frac{P_1 V_{max} + P_2 V_{min}}{2};$$

Wherein, $P_1$ and $P_2$ are positive factors whose values are both more than 0 and less than 1;
Step 5: Match the ET power supply or APT power supply with the transistor;
Step 5.1: Obtain the impedance R2 at the end face of Plan A of the output terminal for the transistor current source when the transistor outputs the average power according to the optimal load value R1 of the selected ET power supply or APT power supply and the drain efficiency DE when the transistor outputs the rated power;
The specific calculation formula is as follows:

$$\frac{V_{rms}^2 * DE}{R_1} = \frac{(V_{rms} - V_1)^2}{2R_2},$$

Wherein, $V_1$ is the characteristic voltage of the transistor, and the drain efficiency DE for the transistor to output the rated power is obtained when Step 3 is performed;
Step 5.2: Convert the impedance of the load to the impedance R2 at the end face of Plan A of the output terminal for the transistor current source based on the Smith chart impedance transformation method to realize the matching of ET power supply or APT power supply with the transistor;
Step 6: The building of power amplifier circuit based on envelope tracking technology is completed.

4. The design method of the power amplifier circuit based on envelope tracking technology and Doherty architecture according to Claim 3, **characterized in that** Advanced Design System is used as the simulation software.

FIG. 1

FIG. 2

FIG. 3

FIG. 4

## INTERNATIONAL SEARCH REPORT

| International application No. |
|---|
| **PCT/CN2022/085470** |

**A. CLASSIFICATION OF SUBJECT MATTER**

H03F 1/02(2006.01)i

According to International Patent Classification (IPC) or to both national classification and IPC

**B. FIELDS SEARCHED**

Minimum documentation searched (classification system followed by classification symbols)

H03F

Documentation searched other than minimum documentation to the extent that such documents are included in the fields searched

Electronic data base consulted during the international search (name of data base and, where practicable, search terms used)

CNABS; CNTXT; DWPI; VEN; ENTXT; USTXT; WOTXT; EPTXT; CNKI; IEEE: 包络跟踪, 多尔蒂, 功率放大, 平均功率跟踪, 电源, 饱和功率, 峰均比, 晶体管, 漏极, envelope tracking, Doherty, power amplification, average power tracking, power supply, saturation power, peak to average ratio, transistor, drain

**C. DOCUMENTS CONSIDERED TO BE RELEVANT**

| Category* | Citation of document, with indication, where appropriate, of the relevant passages | Relevant to claim No. |
|---|---|---|
| PX | CN 114285378 A (SHAANXI REACTOR MICROELECTRONICS CO., LTD.) 05 April 2022 (2022-04-05) claims 1-4, description, paragraphs 69-99, and figures 3-4 | 1-4 |
| E | CN 114400975 A (SHAANXI SUB FINISHED MICROELECTRONIC CO., LTD.) 26 April 2022 (2022-04-26) claims 1, 3-5, description, paragraphs 19-40, and figure 3 | 1-4 |
| X | CN 112422088 A (FINE MADE MICROELECTRONICS GROUP CO., LTD.) 26 February 2021 (2021-02-26) description, paragraphs 57-87, and figures 1-3 | 1-2 |
| A | CN 112422088 A (FINE MADE MICROELECTRONICS GROUP CO., LTD.) 26 February 2021 (2021-02-26) description, paragraphs 57-87, and figures 1-3 | 3-4 |
| X | US 2020350866 A1 (SKYWORKS SOLUTIONS INC.) 05 November 2020 (2020-11-05) description, paragraphs 103-106, 114-137, and 152-157, and figures 6, 9-10, and 12 | 1, 2, |
| A | US 2020350866 A1 (SKYWORKS SOLUTIONS INC.) 05 November 2020 (2020-11-05) description, paragraphs 103-106, 114-137, and 152-157, and figures 6, 9-10, and 12 | 3-4 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **04 August 2022** | **21 September 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2022/085470** |

**C.     DOCUMENTS CONSIDERED TO BE RELEVANT**

| Category* | Citation of document, with indication, where appropriate, of the relevant passages | Relevant to claim No. |
| --- | --- | --- |
| A | US 2016315586 A1 (TOSHIBA K. K.) 27 October 2016 (2016-10-27)<br>description, paragraphs 2 and 8, and figure 1 | 1-4 |
| A | JP 2012049858 A (HITACHI KOKUSAI ELECTRIC INC.) 08 March 2012 (2012-03-08)<br>entire document | 1-4 |
| A | WO 2021161721 A1 (MURATA MANUFACTURING CO., LTD.) 19 August 2021<br>(2021-08-19)<br>entire document | 1-4 |

Form PCT/ISA/210 (second sheet) (January 2015)

**INTERNATIONAL SEARCH REPORT**
Information on patent family members

International application No.

**PCT/CN2022/085470**

| Patent document cited in search report | | | Publication date (day/month/year) | Patent family member(s) | | | Publication date (day/month/year) |
|---|---|---|---|---|---|---|---|
| CN | 114285378 | A | 05 April 2022 | None | | | |
| CN | 114400975 | A | 26 April 2022 | None | | | |
| CN | 112422088 | A | 26 February 2021 | CN | 213783248 | U | 23 July 2021 |
| US | 2020350866 | A1 | 05 November 2020 | US | 11165393 | B2 | 02 November 2021 |
| US | 2016315586 | A1 | 27 October 2016 | JP | 2015126432 | A | 06 July 2015 |
| | | | | WO | 2015098149 | A1 | 02 July 2015 |
| | | | | EP | 3089359 | A1 | 02 November 2016 |
| | | | | JP | 5833094 | B2 | 16 December 2015 |
| | | | | CN | 105850036 | A | 10 August 2016 |
| JP | 2012049858 | A | 08 March 2012 | JP | 5522843 | B2 | 18 June 2014 |
| WO | 2021161721 | A1 | 19 August 2021 | None | | | |

Form PCT/ISA/210 (patent family annex) (January 2015)